# EUROPÄISCHE PATENTANMELDUNG

(11) **EP 4 075 933 A1**
(43) Veröffentlichungstag der Anmeldung: **19.10.2022**
(21) Anmeldenummer: 21168331.3
(22) Anmeldetag: 14.04.2021
(51) Int. Cl.: H05K 7/20

(54) **WÄRMETAUSCHERANORDNUNG**

(71) Anmelder: Siemens Aktiengesellschaft, 80333 München (DE)
(72) Erfinder: Neumann, Ralph, 09113 Chemnitz (DE); Pöhler, Dirk, 08141 Reinsdorf (DE); Scherzer, Christian, 09423 Gelenau (DE)

(57) **Zusammenfassung**

Die Erfindung betriff eine Wärmetauscheranordnung (1) ausgestaltet zur Schaltschrankkühlung durch Wärmeübertragung von Verlustwärme, hervorgerufen von elektronischen Komponenten (K) innerhalb des Schaltschranks (2), umfassend ein Übertragungsmittel (10) ausgestaltet die Verlustwärme von einem ersten Kühlmedium (M1) innerhalb des Schaltschranks (2) für die elektronischen Komponenten (K) durch das Übertragungsmittel (10) auf ein zweites Kühlmedium (M2) außerhalb des Schaltschanks (2) zu übertragen, mit einer Wanne (23) mit einer Oberseite (30), einer Unterseite (33), einer ersten Längsseite (31) und einer zweiten Längsseite (32), wobei
• In der Wanne (23) eine Ausnehmung (26,27) angeordnet ist und in der Ausnehmung (26,27) das Übertragungsmittel (10) angeordnet ist, wobei
• ein erstes Mediumleitblech (22) derart auf der Wanne (23) angeordnet ist, dass ein Strömungskanal für eine Außenströmung (AS) zwischen dem ersten Mediumleitblech (22) und der Wanne (23) entsteht, wobei das erste Mediumleitblech (22) ausgestaltet ist, dass das zweite Kühlmedium (M2) an der Unterseite (33) eintritt und an der Oberseite (30) austritt, wobei
• ein zweites Mediumleitblech (24) derart auf der dem ersten Mediumleitblech (22) gegenüberliegenden Seite der Wanne (23) angeordnet ist, dass ein Strömungskanal für eine Innenströmung (IS), zwischen dem zweiten Luftleitblech (24) und der Wanne (23) entsteht, wobei das zweite Mediumleitblech (22) ausgestaltet ist, dass das erste Kühlmedium (M1) an der Oberseite (30) eintritt und an der Unterseite (33) austritt,
• wodurch eine senkrechte und gegenläufige Führung von Au-βenströmung (AS) zu Innenströmung (IS) erreicht wird.

## Beschreibung

Die Erfindung betrifft eine Wärmetauscheranordnung ausgestaltet zur Schaltschrankkühlung durch Wärmeübertragung von Verlustwärme, hervorgerufen von elektronischen Komponenten innerhalb des Schaltschranks, umfassend ein Übertragungsmittel ausgestaltet die Verlustwärme von einem ersten Kühlmedium innerhalb des Schaltschranks für die elektronischen Komponenten durch das Übertragungsmittel auf ein zweites Kühlmedium außerhalb des Schaltschanks zu übertragen.

Bei Roboter Anwendungen ist die Maßgabe, dass der Schaltschrank zur Steuerung des Roboters seitlich anreihbar und stapelbar sein soll. Weiterhin soll kein Luftaustausch zwischen Umgebung und dem Inneren des Schrankes stattfinden. Es wird aber im Schaltschrank so viel Verlustleistung erzeugt, dass ein Kühlsystem notwendig ist. Das Kühlsystem soll wartungsfrei/ -arm ausgelegt sein.

Zur Kühlung von Schaltschränken wurden bisher aktive Kühlgeräte (Anbaugeräte), Wärmetauscher oder Lüfter in oder auf die Tür oder die Seitenwand oder das Dach des Schaltschranks montiert. Dies beschränkt aber die Montage von mehreren Schaltschränken nebeneinander, da diese Kühlgeräte an den Schaltschrank montiert werden müssen und einen entsprechenden Freiraum benötigen bzw. den Raum vor dem Schaltschrank einschränken.

Es ist Aufgabe der vorliegenden Erfindung eine Wärmetauscheranordnung bzw. ein Kühlsystem anzugeben, welches die o.g. Forderungen erfüllt.

Mit der eingangs genannten Wärmetauscheranordnung wird die Aufgabe dadurch gelöst, dass die Wärmetauscheranordnung aufgebaut ist mit einer Wanne, wobei die Wanne eine Oberseite, eine Unterseite, eine erste Längsseite und eine zweite Längsseite umfasst, wobei in der Wanne eine Ausnehmung angeordnet ist und in der Ausnehmung das Übertragungsmittel angeordnet ist, wobei ein erstes Mediumleitblech derart auf der Wanne angeordnet ist, dass ein Strömungskanal für eine Außenströmung zwischen dem ersten Mediumleitblech und der Wanne entsteht, wobei das erste Mediumleitblech ausgestaltet ist, dass das zweite Kühlmedium an der Unterseite eintritt und an der Oberseite austritt, wobei ein zweites Mediumleitblech derart auf der dem ersten Mediumleitblech gegenüberliegenden Seite der Wanne angeordnet ist, dass ein Strömungskanal für eine Innenströmung zwischen dem zweiten Luftleitblech und der Wanne entsteht, wobei das zweite Mediumleitblech ausgestaltet ist, dass das erste Kühlmedium an der Oberseite eintritt und an der Unterseite austritt, wodurch eine senkrechte und vorzugsweise gegenläufige Führung von Außenströmung und Innenströmung erreicht wird.

Mit diesem Aufbau einer Wanne und einer außenseitigen Abdeckung mit einem ersten Mediumleitblech und einer innenseitigen Abdeckung mit einem zweiten Mediumleitblech kann ein Gegenstromprinzip für eine Kühlung, beispielsweise eine Luftkühlung ausgenutzt werden. Es werden damit zwei getrennte Kühlkreisläufe erreicht, welches einer Schutzklasse IP54 entgegenkommt. Demnach kann ein Kühlmittelstrom von einer Außenströmung über das Übertragungsmittel von einer ersten Seite hinweggeführt werden und mit einer Innenströmung kann das erste Kühlmittel im Inneren des Schaltschrankes über das Übertragungsmittel von einer zweiten Seite hinweggeführt werden. Durch die Bauweise einer Wanne mit beidseitig abgedeckten Luftleitblechen, wobei in der Wanne mittig platziert das Übertragungsmittel, beispielsweise ausgestaltet als Kühlkörper, platziert ist, erreicht man eine besonders flache Bauweise im Hinblick auf die Integration in einer Rückseite eines Schaltschrankes. Eine derartige Wärmetauscheranordnung ist nun als Kühlsystem beispielsweise in der Rückseite hinter einer Montageplatte in einem Schaltschrank integrierbar. In der Regel weisen die Standardschaltschränke eine Bautiefe von 500 mm auf. Da man mit der Aufbauweise dieser Wärmetauscheranordnung in einem Bereich von 10 - 15 cm liegt, kann die Wärmetauscheranordnung sehr gut in einen Schaltschrank mit Steuerungskomponenten für Roboter integriert werden.

In einer weiteren Ausgestaltung weist das erste Mediumleitblech im Bereich der Unterseite einen Einlass auf, in welchem ein Lüfter zum Ansaugen des zweiten Mediums angeordnet ist.

In einer weiteren verbesserten Ausgestaltung weist das zweite Mediumleitblech im Bereich der Oberseite einen Einlass auf, in welchem ein weiterer Lüfter zum Ansaugen des ersten Mediums angeordnet ist. Für eine Integration in einen Schaltschrank weist die Wärmetauscheranordnung an der ersten Längsseite ein erstes Haltemittel und an der zweiten Längsseite ein zweites Haltemittel auf. Damit ist eine individuelle Montage an verschiedensten Schrankstellen innerhalb der Rückseite möglich, da der Aufbau immer auf standardisierte und genormte Teile erfolgt.

Im Hinblick auf eine effektive Kühlung weist das Übertragungsmittel eine erste Rippenstruktur auf, welche derart angeordnet ist, dass das erste Kühlmedium eine vertikale Führung erfährt und somit eine Strömungsrichtung des erstens Kühlmediums senkrecht ist.

Noch weiter kann die Wärmeübertragung optimiert werden, wenn das Übertragungsmittel eine zweite Rippenstruktur aufweist, welche derart angeordnet ist, dass das zweite Kühlmedium eine vertikale Führung erfährt und somit eine Strömungsrichtung des zweiten Kühlmediums senkrecht ist.

Eine weitere Optimierung der Wärmeübertragung wird erreicht, wenn das Übertragungsmittel eine Schichtstruktur mit einer ersten Schicht, einer zweiten Schicht und einer dritten Schicht aufweist, dabei ist zumindest die erste Schicht aus einem Poren aufweisenden Stoff ausgestaltet, bei welchen ein Verhältnis eines Gesamtvolumens der ersten Schicht zu einem durch die Poren gebildeten Hohlraumvolumen der ersten Schicht derart optimiert ist, dass eine daraus resultierende Porengröße ein Optimum für eine Wärmeleitfähigkeit der ersten Schicht und einem Strömungswiderstand für das Kühlmedium durch die Poren bildet.

Durch den Einsatz eines porösen Stoffes bei einem Wärmetauscher bzw. Kühlkörper, kann beim selben Volumen mehr Oberfläche generiert werden. Somit kann mehr Wärmeenergie aufgenommen bzw. abgegeben werden. Hier ist ein optimiertes Verhältnis dieses, welches eine maximale Fläche im definierten Volumen bei einem geringen Staudruck des angestrebten Kühlmediums abbildet. Vorteilhafter Weise ist das Ergebnis, dass deutlich mehr Energie aufgenommen bzw. abgegeben werden kann. Nach Berechnungen mit einem Extremwert- bzw. Optimierungswert-Problem kann damit gerechnet werden, dass nahezu eine verdoppelte Effektivität einer Wärmetauscheranordnung zum Kühlen hergestellt werden kann, als es bei Standard-Kühlkörpern, beispielsweise einem aus Vollmaterial, der Fall ist. Das hat den Vorteil, dass mit einem halbierten Volumen die gleich Kühlleistung erreichen kann.

Je nach Porengröße liegt eine Wärmeleitfähigkeit des verwendeten Stoffes im Bereich von 30 bis 50 Watt pro Meter Kelvin.

Somit kann die Wärme von einem Ort, beispielsweise aus dem Inneren eines Schaltschrankes, zu einem anderen Ort, beispielsweise außerhalb des Schaltschrankes, durch eine Strömung durch die Poren des ersten zu kühlenden Mediums transportiert werden.

In einer vorteilhaften Ausgestaltung der Wärmetauscheranordnung ist die zweite Schicht aus einem Vollmaterial, welches für das erste Kühlmedium undurchlässig ist, ausgestaltet. Insbesondere bei einer Anwendung in einen Schaltschrank ist die Ausgestaltung der zweiten Schicht als ein Vollmaterial dahingehend vorteilhaft, dass das erste Kühlmedium nicht nach außen wegströmen kann bzw. eine Wärmetauscheranordnung den Raum mit den elektronischen Komponenten nach außen hin abdichtet.

Eine Wärmeübertragung bzw. Energieübertragung oder Wärmeleitfähigkeit kann bei der Wärmetauscheranordnung dadurch verbessert werden, dass die dritte Schicht ebenfalls aus einem Poren aufweisenden Stoff ausgestaltet ist, bei welchem ein Verhältnis eines Gesamtvolumens der dritten Schicht zu einem durch die Poren gebildeten Hohlraumvolumen der dritten Schicht derart optimiert ist, dass eine daraus resultierende Porengröße und ein Optimum für eine Wärmeleitfähigkeit der dritten Schicht und einem Strömungswiderstand für das zweite Kühlmedium durch die Poren bildet.

Die dritte Schicht, für den Fall, dass sie nach außen zeigt und das zweite Kühlmedium eine Umweltluft ist, kann weiterhin dahingehend porentechnisch ausgestaltet sein, dass die Poren derart groß sind, dass eine Luftverschmutzung die Poren nicht zusetzt.

Als besonders vorteilhaft für den Stoff wird poröses Aluminium angesehen. Poröses Aluminium ist für gasförmige und flüssige Medium durchlässig.

Vorteilhaft ist es, wenn der poröse Stoff derart ausgestaltet ist, dass im Wesentlichen alle Poren miteinander in Verbindung stehen und eine Porenmatrix vorhanden ist.

Eine Porengröße liegt im Bereich von 0,2 mm bis 2,0 mm. Man erreicht eine hohe Maßzahl für ein Verhältnis von innerer Oberfläche in Quadratmeter zu dem Gesamtvolumen in Kubikmetern. Beispielsweise ist bei einer Porengröße von 0,3 mm bis 0,5 mm das Verhältnis von innerer Oberfläche zu Gesamtvolumen ca. 10.000.

Im Hinblick auf die Kühlung von elektrischen Komponenten in einem Schaltschrank ist die Wärmetauscheranordnung ausgestaltet zur Integration in eine Rückwand eines Schaltschrankes. Zur Abdichtung weist die Wärmetauscheranordnung eine umlaufende Nut für eine Dichtung auf.

Die eingangs genannte Aufgabe wird ebenso durch einen Schaltschrank mit einem innerhalb des Schaltschrankes zur Rückseite gerichteten Wärmetauscher nach einem der Ansprüche 1 - 13 gelöst.

Insbesondere bei einem Einsatz eines Schaltschrankes für eine Anlage (z.B. Antriebssteuerung) für den Einsatz an einem Roboter ist es vorteilhaft, dass dieser Schrank in räumlicher Nähe neben dem Roboter platziert werden kann. Der Schrank muss dabei seitlich anreihbar und stapelbar sein, beispielsweise für weitere zu steuernde Roboter. Um die elektrischen Komponenten in den Schaltschränken zu kühlen, wobei die elektrischen Komponenten in der Regel Stromrichter für die Motoren der Roboter sind, wird der Wärmetauscher in den Schaltschrank integriert. Erfindungsgemäß wird eine senkrechte Luftführung im Gegenstromprinzip erreicht. Auch ein Einsatz von Axiallüftern in einem Innen- und Außenkreislauf verbessert die Kühlwirkung. Eine Einbautiefe der Wärmetauscheranordnung liegt im Bereich von 12 cm und ist somit platzsparend und voll integrierbar in einen Schaltschrank mit einer Montageplatte, auf welcher die elektrischen Komponenten platziert sind. Als Übertragungsmittel wird vorzugsweise ein Kühlkörper mit Finnen bzw. Rippen auf beiden Seiten und einer umlaufenden Dichtung eingesetzt.

Der neuartige Wärmetauscher kann demnach in der Rückseite des Schaltschrankes hinter der Montageplatte integriert werden. Diese neuartige Wärmetauscheranordnung ist deutlich platzsparender, da die Wärmetauscheranordnung in einem 500 mm tiefen Schaltschrank vollkommen integriert werden kann. Die Wärmetauscheranordnung ist nahezu wartungsfrei, da keine Filtermatten nötig sind und ein getrennter Innen- und Außenkreislauf vorhanden ist. Die Wärmetauscheranordnung hat mit ca. 100 W/K eine sehr gute Kühlleistung für beispielsweise einen Luft-Wärmetauscher. Darüber hinaus ist die erfindungsgemäße Wärmetauscheranordnung noch ca. um ein Drittel kostengünstiger als derzeit bekannte vergleichbare Klimageräte für Schaltschränke.

Im Hinblick auf ein Übertragungsmittel kann gesagt werden, dass ein Wärmetauscher aus porösen Aluminium, insbesondere im Aufbau mit drei Schichten, wobei eine mittlere Schicht ein Vollmaterial ist, für die Anwendung als Wärmetauscher hervorragend geeignet ist. Für die Wärmeübertragung wird aufgrund der guten Wärmeleitfähigkeit überwiegend Aluminium verwendet. Eine Wärmetauschfähigkeit von porösen Aluminium ist höher als bei herkömmlich verarbeitetem Aluminium, da poröses Aluminium im Verhältnis zum Volumen eine sehr große Oberfläche hat.

Es sind auch hybride Ausführungsformen möglich, indem beispielsweise das Kühlmedium im inneren des Schaltschrankes (oder alternativ das äußere Kühlmedium) durch einen Wärmetauscher-Teil aus porösem Aluminium geführt wird. Die nächste Schicht besteht aus Medium-undurchlässigem Material, und die dritte Schicht ist dann eine Korrosionsschutzschicht, beispielsweise ein Lack, eine Eloxierung oder dergleichen. Die Oberfläche dieser Seite des Wärmetauschers ist dann vorteilhaft als Rippenstruktur oder dergleichen ausgeformt.

Der große Vorteil von porösen Aluminium ist seine Durchlässigkeit für Flüssigkeiten und Gase. Wenn beispielsweise eine Flüssigkeit oder ein Gas durch einen Block von porösen Aluminium strömt, dann kann dieses Gas oder diese Flüssigkeit viel mehr Wärmeenergie aufgrund einer großen Kontaktfläche aufnehmen bzw. austauschen.

Die Zeichnung zeigt ein Ausführungsbeispiel. Dabei zeigt:
- FIG 1: einen Standardschaltschrank mit 500 mm Einbautiefe,
- FIG 2: den in FIG 1 gezeigten Schaltschrank in einer Schnittdarstellung mit Blick auf Komponenten und der Wärmetauscheranordnung,
- FIG 3: die Wärmetauscheranordnung in einer perspektivischen Darstellung mit Blick auf eine Außenseite,
- FIG 4: die Wärmetauscheranordnung aus Figur 3 mit entferntem ersten Mediumleitblech mit Blick auf ein Übertragungsmittel,
- FIG 5: die Wärmetauscheranordnung in einer perspektivischen Darstellung mit Blick auf eine Innenseite,
- FIG 6: eine Wanne, als Anbauteil für weitere Komponenten,
- FIG 7: einen Wärmetauscher in einem Schaltschrank,
- FIG 8: den Wärmetauscher in dem Schaltschrank in der Darstellung mit getrennten Kühlmedien,
- FIG 9: einen schematischen Wärmetauscher mit Rippenstruktur,
- FIG 10: eine Porenmatrix,
- FIG 11: eine Draufsicht auf einen Wärmetauscher mit einer ersten Rippenstruktur und einer zweiten Rippenstruktur,
- FIG 12: eine Innenseite des Wärmetauschers mit Sicht auf die erste Rippenstruktur und
- FIG 13: eine Außenseite des Wärmetauschers mit Sicht auf die zweite Rippenstruktur.

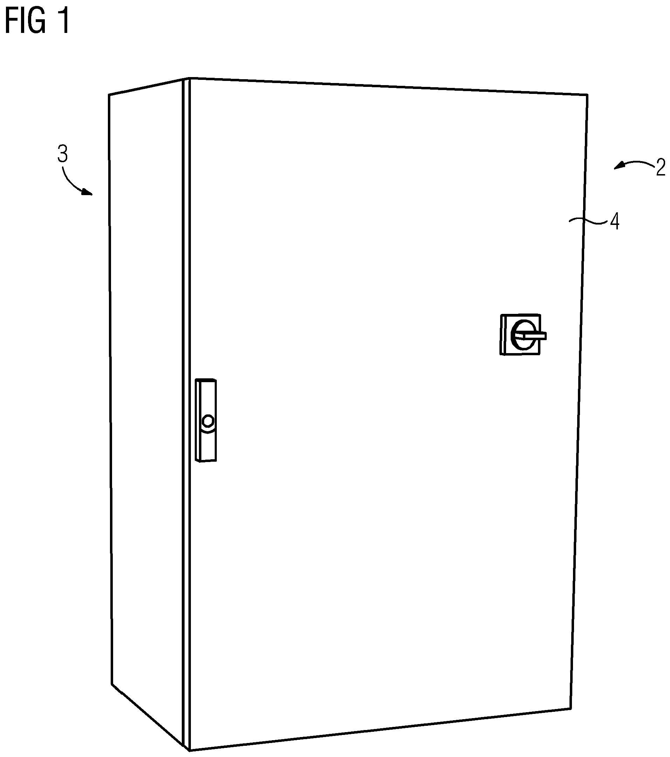

Gemäß FIG 1 ist ein Schaltschrank 2 mit einer Vorderseite 4 (Tür) und einer Rückseite 3 dargestellt.

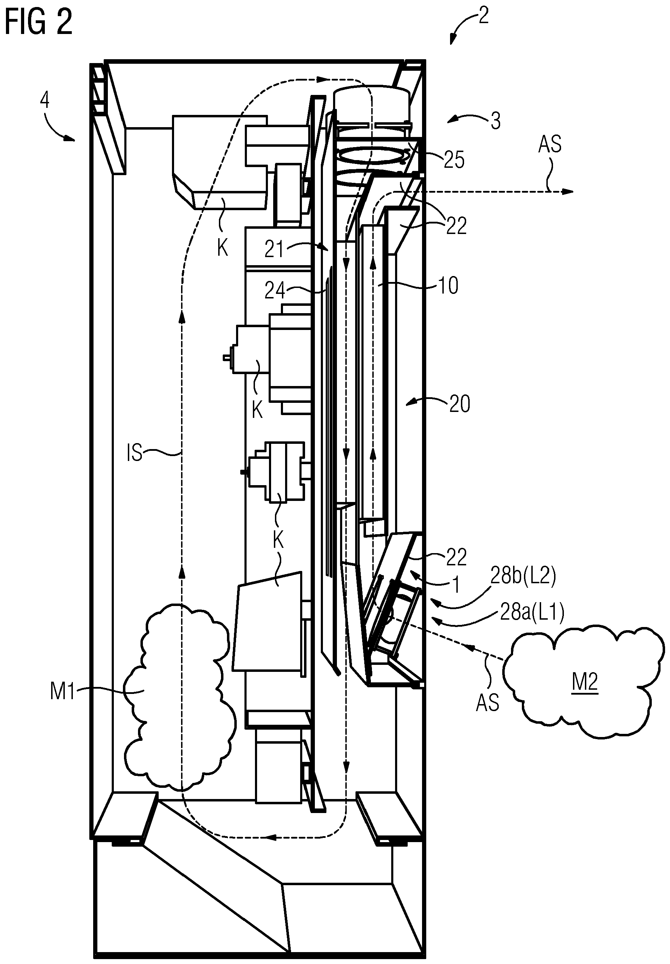

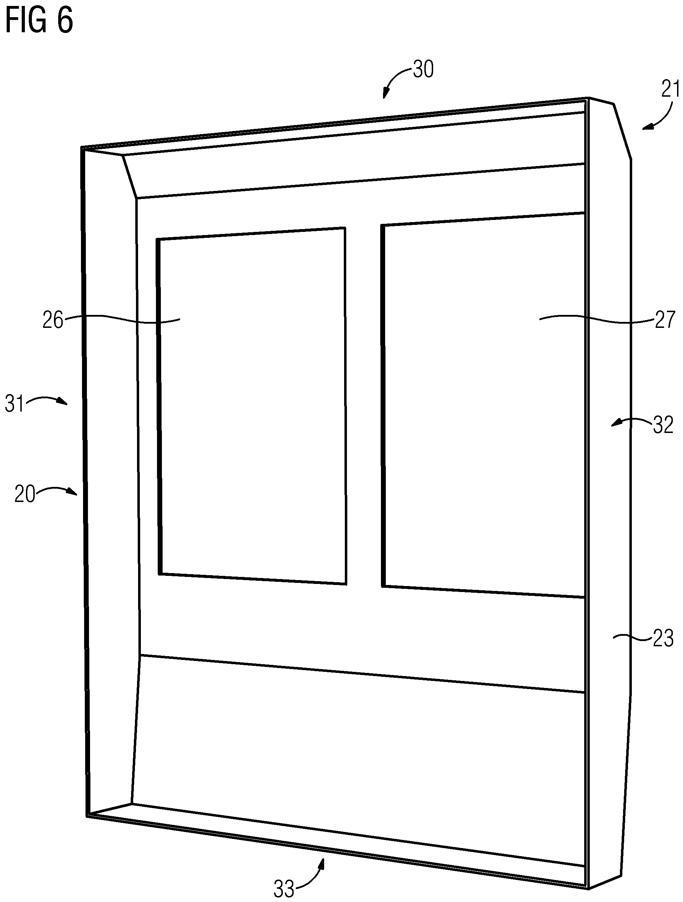

Die FIG 2 zeigt den aus FIG 1 bekannten Schaltschrank 2 in einer Schnittdarstellung. Innerhalb des Schaltschrankes 2 ist zur Rückseite 3 eine Wärmetauscheranordnung 1 eingebaut. In dem Schaltschrank 2 befinden sich elektronische Komponenten K, welche in ihrem Betrieb Verlustwärme erzeugen. Innerhalb des Schaltschrankes 2 befindet sich ein erstes Kühlmedium M1 und außerhalb des Schaltschrankes 2 befindet sich ein zweites Kühlmedium M2. Die Wärmetauscheranordnung 1 ist nun ausgestaltet zur Schaltschrankkühlung durch Wärmeübertragung von Verlustwärme, welche durch die elektronischen Komponenten K innerhalb des Schaltschrankes hervorgerufen wird. Dazu weist die Wärmetauscheranordnung 1 ein Übertragungsmittel 10 auf, welches ausgestaltet ist, die Verlustwärme von dem ersten Kühlmedium M1 innerhalb des Schaltschrankes 2 durch das Übertragungsmittel 10 auf das zweite Kühlmedium M2 außerhalb des Schaltschranks 2 zu übertragen. Als Basiskomponente weist die Wärmetauscheranordnung 1 eine Wanne 23 mit einer Oberseite 30, einer Unterseite 33, einer ersten Längsseite 31 und einer zweiten Längsseite 32 (siehe insbesondere FIG 6) auf. In der Wanne 23 ist eine erste Ausnehmung 26 und eine zweite Ausnehmung 27 angeordnet, wobei das Übertragungsmittel 10 in der Ausnehmung 26, 27 angeordnet ist. Ein erstes Mediumleitblech 22 ist derart auf der Wanne angeordnet, dass ein Strömungskanal für eine Außenströmung AS zwischen dem ersten Mediumleitblech 22 und der Wanne 23 entsteht. Das erste Mediumleitblech 22 ist dabei ausgestaltet, dass das zweite Kühlmedium M2 an der Unterseite 33 eintritt und an der Oberseite 30 austritt. Ein zweites Mediumleitblech ist derart auf der dem ersten Mediumleitblech 22 gegenüberliegenden Seite der Wanne angeordnet, dass ein Strömungskanal für eine Innenströmung IS zwischen dem zweiten Luftleitblech 24 und der Wanne entsteht, wobei das zweite Mediumleitblech 22 ausgestaltet ist, dass das erste Kühlmedium M1 an der Oberseite 30 eintritt und an der Unterseite 33 austritt.

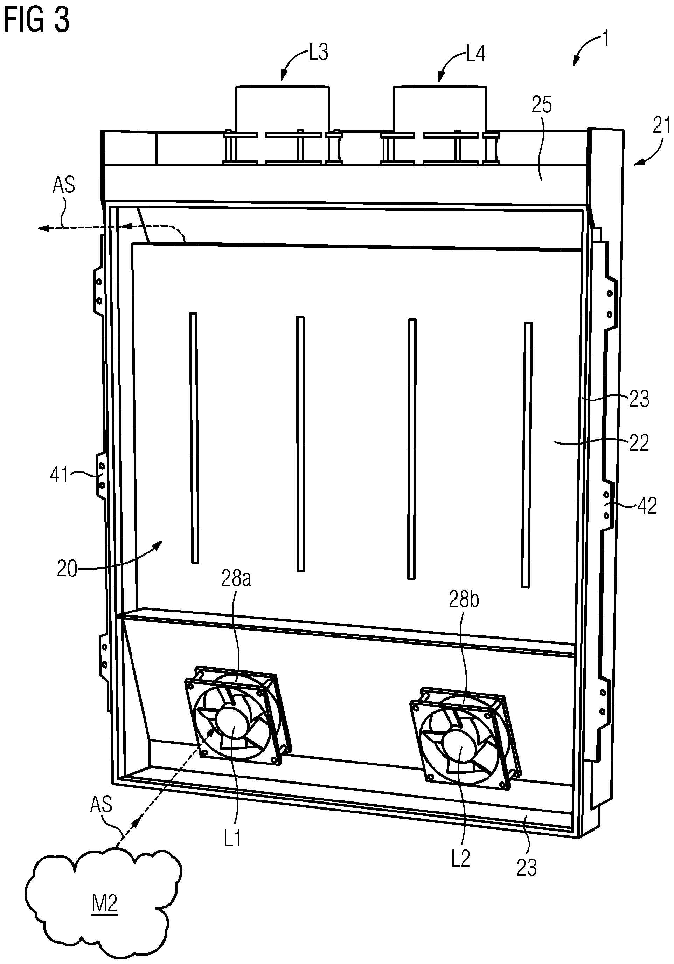

Durch diese Anordnung wird eine senkrechte und gegenläufige Führung von der Außenströmung AS zu der Innenströmung erreicht. Das erste Mediumleitblech 22 weist im Bereich der Unterseite einen ersten Einlass 28a und einen zweiten Einlass 28b auf, in welchem jeweils ein erster Lüfter L1 und ein zweiter Lüfter L2 angeordnet ist (siehe Figur 3). Alternativ können die Strömungsrichtungen der gegenläufigen Strömung (innen - außen) auch in umgekehrter Richtung oder parallel oder sogar orthogonal zueinander verlaufen.

Betrachtet man die Strömungsverläufe im Inneren des Schaltschrankes 2 gemäß Figur 2, so ist ersichtlich, dass die Innenströmung IS im oberen Teil durch einen dritten Lüfter L3 und einen vierten Lüfter L4, welche in einer Lüfterkassette 25 angeordnet sind, entstehen kann. Beispielsweise wird warme Luft, welche sich im oberen Teil des Schaltschrankes angestaut hat, regelrecht abgesaugt und zwangsgeführt durch die Wärmetauscheranordnung durch den durch das zweite Mediumleitblech gebildeten Strömungskanal für die Innenströmung IS geführt und an einer vorzugsweise rippenförmigen Struktur des Übertragungsmittels zur Entwärmung vorbeigeführt. Im Gegenzug wird durch den ersten Lüfter L1 und den zweiten Lüfter L2, welche in dem ersten Mediumleitblech 22 angeordnet sind, das zweite Kühlmedium M2, insbesondere die Außenluft, angesaugt und gegenläufig zur Innenströmung zwangsgeführt durch den durch das erste Mediumleitblech gebildeten Strömungskanal für die Außenströmung geführt, wobei wiederum über die Kühlrippen des Übertragungsmittels 10 die kühlere Außenluft senkrecht geführt wird.

FIG 3 zeigt in einer perspektivischen Darstellung die Wärmetauscheranordnung 1. Über den ersten Lüfter L1 und den zweiten Lüfter L2 kann das zweite Kühlmedium M2 angesaugt werden und an einer Oberseite 30 der Wanne 33 wieder ausgeblasen werden. Der dritte Lüfter L3 und der vierte Lüfter L4 sind in der Lüfterkassette 25 angeordnet, wobei der dritte L3 und der vierte Lüfter L4 für die Innenströmung IS im Inneren des Schaltschrankes 2 zuständig ist.

Obwohl in den Figuren auf jeder Seite 2 Axiallüfter dargestellt sind, können auch andere Konstellationen betrieben werden, beispielsweise eine abweichende Anzahl Lüfter oder der Einsatz von Radiallüftern. Je nach Platzverhältnissen kann auch eine der Seiten passiv durch Konvektion angeströmt werden. Die Lüfter können auch drehzahlgeregelt sein, insbesondere mittels Thermofühlern, und somit hinsichtlich ihrer Leistung an die jeweiligen Betriebsanforderungen angepasst angesteuert werden.

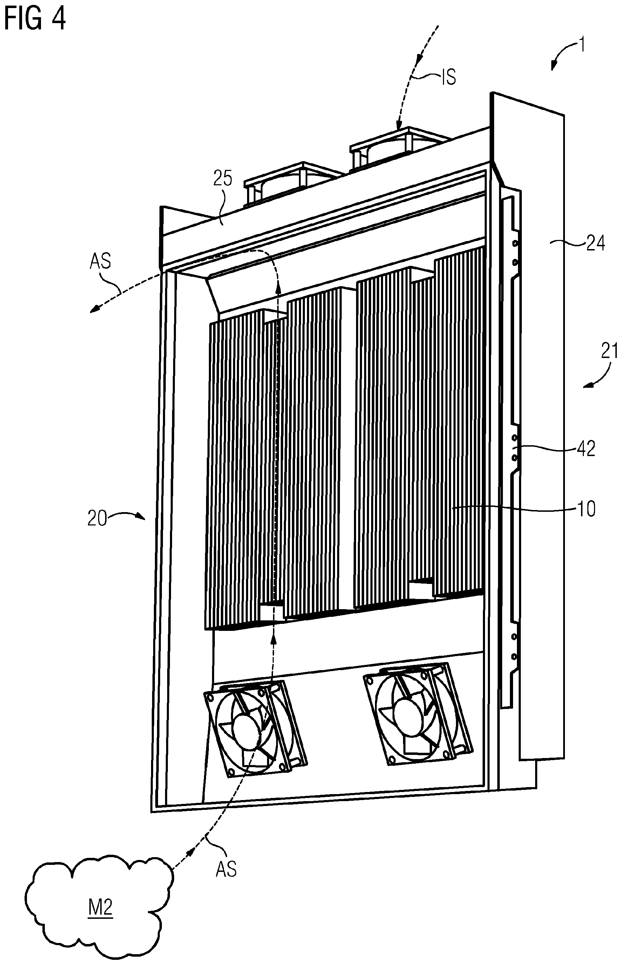

Nochmals mit FIG 4 verdeutlicht wird die Führung der Außenströmung AS über das Übertragungsmittel 10, wobei in der Darstellung aus Figur 4 das erste Mediumleitblech 22 nicht dargestellt ist und somit wird sichtbar, dass die Außenströmung AS durch Kühlrippen des Übertragungsmittels 10 zur Abkühlung geführt wird.

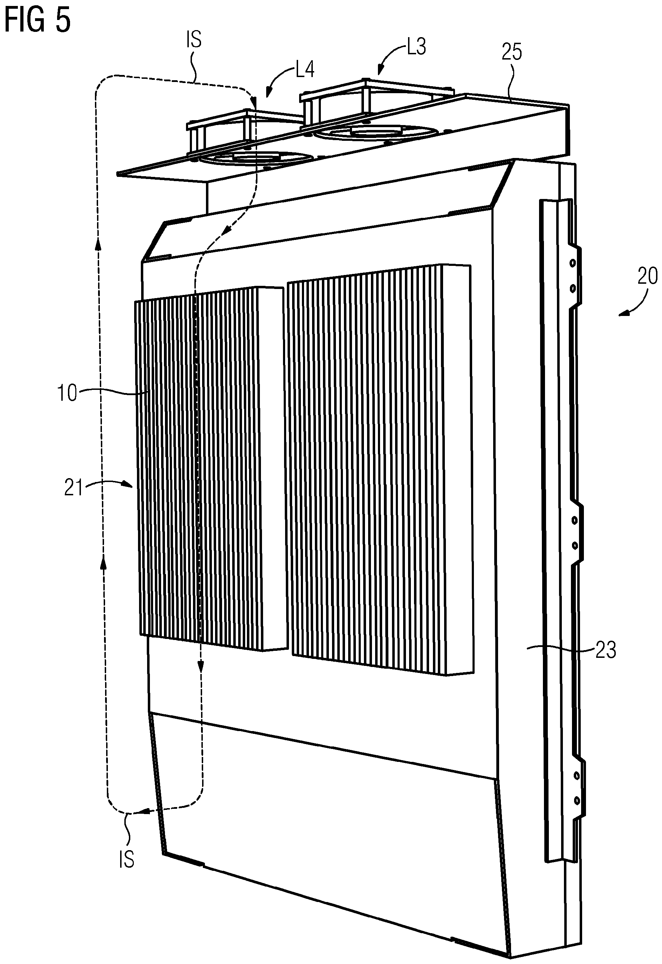

Im Gegensatz dazu zeigt die FIG 5 mit entferntem zweiten Mediumleitblech die Führung der Innenströmung IS durch Kühlrippen des Übertragungsmittels 10. Der dritte Lüfter L3 und der vierte Lüfter L4 saugen im oberen inneren Teil des Schaltschrankes 2 die dort erwärmte Luft an und führen sie zwangsgeführt durch den Strömungskanal für die Innenströmung IS der Wärmetauscheranordnung über die Kühlrippen des Übertragungsmittels 10 hinweg in den unteren Teil des Schaltschrankes 2, wo die Innenströmung als beispielsweise abgekühlte Luft wieder austreten kann und somit die elektronischen Komponenten K im Inneren des Schaltschrankes kühlt.

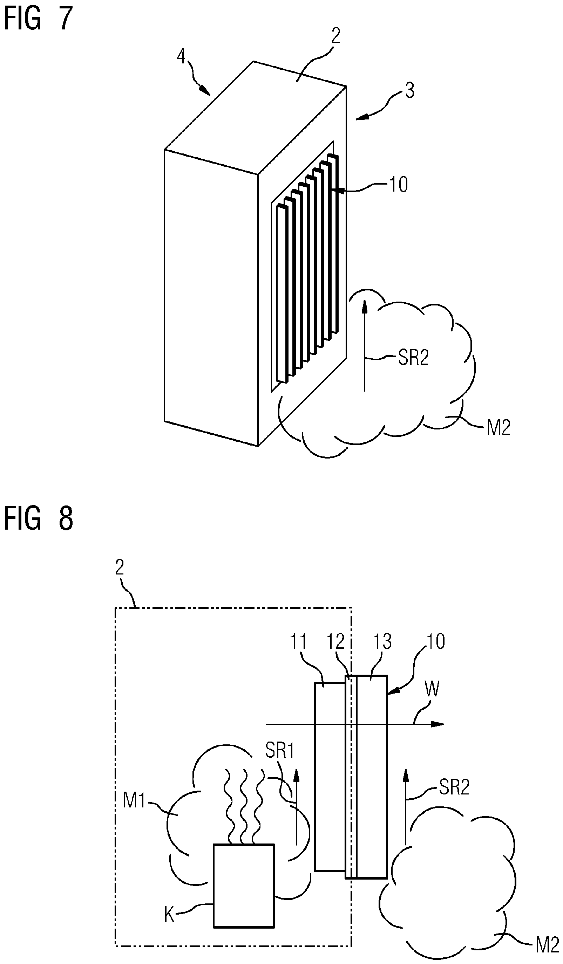

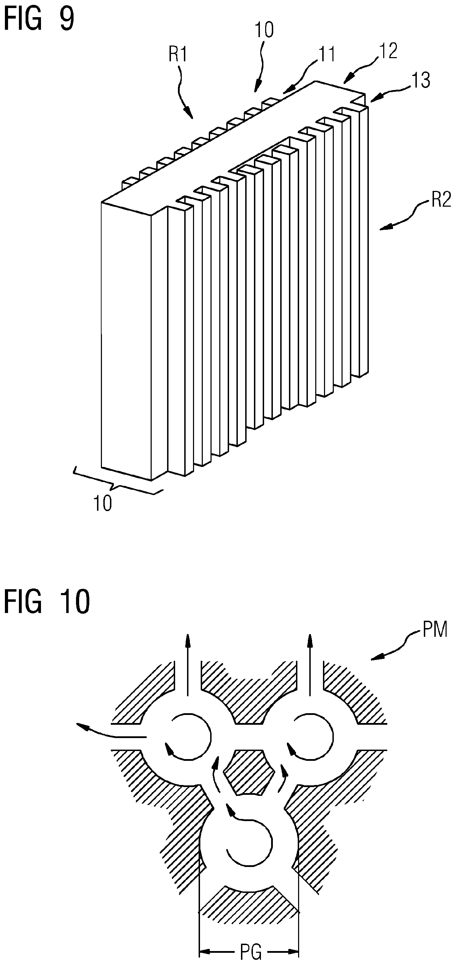

Gemäß FIG 7 ist ein Übertragungsmittel 10 in einem Schaltschrank 2 integriert. Der Schaltschrank 2 weist eine Vorderseite 4 (Tür) und eine Rückseite 3 auf. Vorteilhafterweise ist der Wärmetauscher 1 in der Rückwand der Rückseite 3 des Schaltschrankes 2 integriert. Das Übertragungsmittel 10 weist eine Rippenstruktur auf (siehe FIG 9), wodurch außerhalb des Schaltschrankes 2 zwischen der Rippenstruktur eine zweite Strömungsrichtung SR2 durch ein zweites Kühlmedium M2 entsteht.

Die FIG 8 zeigt schematisch das Übertragungsmittel 10 in einem Schichtenaufbau. Um eine Verlustwärmeableitung von elektronischen Komponenten K innerhalb des Schaltschrankes 2 möglichst effektiv zu gestalten und die thermische Energie von einem ersten Kühlmedium M1 innerhalb des Schaltschrankes 2 nach außen zu übertragen, weist das Übertragungsmittel 10 eine Schichtstruktur mit einer ersten Schicht 11, einer zweiten Schicht 12 und einer dritten Schicht 13 auf. Dabei ist zumindest die erste Schicht 11 aus einem Poren aufweisenden Stoff ausgestaltet, bei welchem ein Verhältnis eines Gesamtvolumens der ersten Schicht 11 zu einem durch die Poren gebildeten Hohlraumvolumen der ersten Schicht 11 derart optimiert ist, dass eine daraus resultierende Porengröße PG (siehe FIG 4) derart optimiert ist, dass ein Optimum für eine Wärmeleitfähigkeit L der ersten Schicht 11 und einem Strömungswiderstand R für das erste Kühlmedium M1 durch die Poren gebildet wird. Die FIG 8 zeigt zur Vereinfachung eine Anordnung ohne Lüfter, also mit reiner Konvektion und daher auf beiden Seiten der Wärmetauscheranordnung dieselbe Strömungsrichtung.

Weist die erste Schicht 11 eine erste Rippenstruktur R1 und die dritte Schicht 13 ein zweite Rippenstruktur R2 auf, so wie in FIG 3 abgebildet, so entsteht im Inneren des Schaltschrankes 2 eine erste Strömungsrichtung SR1 für das erste Kühlmedium M1 und außerhalb des Schaltschrankes 2 entsteht durch die zweite Rippenstruktur R2 eine zweite Strömungsrichtung SR2 des zweiten Kühlmediums M2.

Ein Wärmeübergang W vom Inneren des Schaltschrankes 2 nach außen wird durch die Wärmetauscheranordnung 1 realisiert.

FIG 9 zeigt schematisch die Wärmetauscheranordnung 1 mit ihren drei Schichten, wobei die erste Schicht 11 eine erste Rippenstruktur R1 aufweist, und diese Rippenstruktur aus einem porösen Aluminium ausgestaltet ist. Die zweite Schicht 12 ist aus einem Vollmaterial hergestellt, damit ein Innenraum des Schaltschrankes 2 von einem Außenraum hermetisch abgeriegelt ist. Die dritte Schicht 13 ist ebenfalls aus einem porösen Aluminium ausgestaltet, damit die Wärmeübertragung W effektiver wird. Die ganze Schichtstruktur kann auch als Übertragungsmedium 10 angesehen werden.

Gemäß FIG 10 wird eine Porenmatrix PM dargestellt. Das besondere an der Porenstruktur oder Porenmatrix PM in einem porösen Aluminium ist, dass dieser poröse Aluminiumstoff derart ausgestaltet ist, dass im Wesentlichen alle Poren miteinander in Verbindung stehen, wobei mit einer bestimmten Porengröße ein Maximum an Wärmeleitwert L und ein Minimum an Strömungswiderstand R für ein Kühlmedium erreicht werden kann.

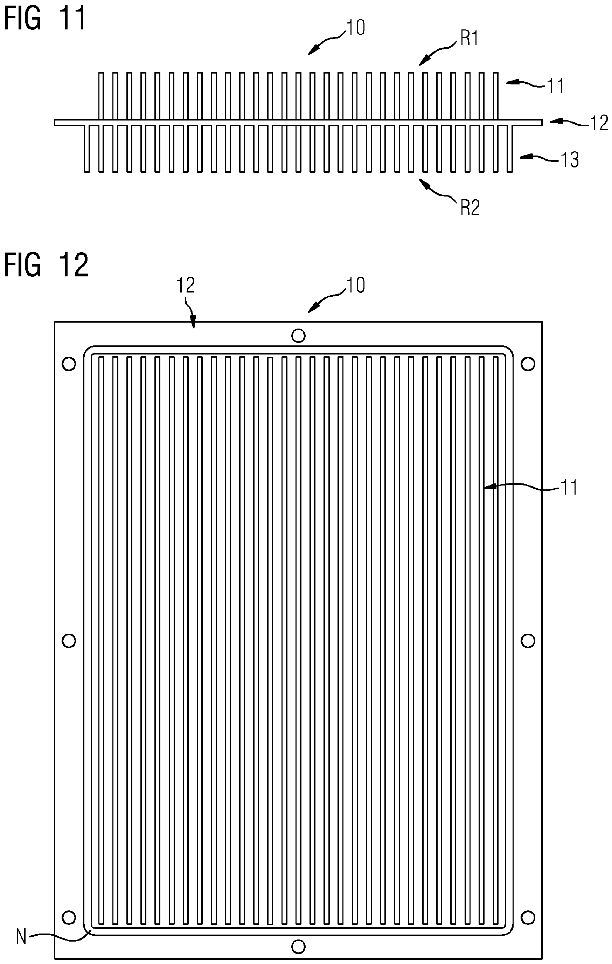

FIG 11 zeigt eine Draufsicht auf eine mögliche Ausgestaltung des Übertragungsmittels 10 mit einer ersten Rippenstruktur R1 und einer zweiten Rippenstruktur R2. Die erste Rippenstruktur R1 zeigt ins Innere des Schaltschrankes 2 und die zweite Rippenstruktur R2 zeigt nach außen. Verdeutlicht wird nochmal der dreischichtige Aufbau von der ersten Schicht 11, der zweiten Schicht 12 und der dritten Schicht 13, wobei die erste Schicht 11 durch die erste Rippenstruktur R1 gebildet ist, die zweite Schicht 12 durch ein Vollmaterial, beispielsweise eine Grundplatte, gebildet ist und die dritte Schicht 13 durch die zweite Rippenstruktur R2 gebildet ist.

Die FIG 12 zeigt das Übertragungsmittel 10 in einer Sicht auf die erste Rippenstruktur 11 (R1 in FIG 11). Um eine Abdichtung des Schaltschrankes 2 nach außen zu erreichen, weist die zweite Schicht 12 aus Vollmaterial eine umlaufende Nut N für eine Dichtung auf.

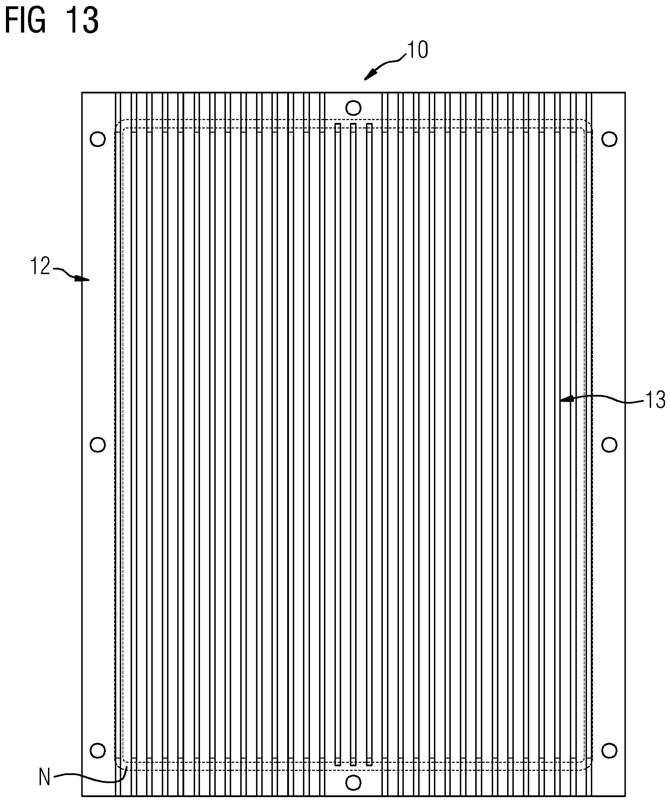

Die FIG 13 zeigt das Übertragungsmittel 10 nach FIG 11 und FIG 12 in einer Sicht auf die zweite Rippenstruktur 13 (R2 in FIG 11), also auf die Außenseite.

## Patentansprüche

1. Wärmetauscheranordnung (1) ausgestaltet zur Schaltschranckühlung durch Wärmeübertragung von Verlustwärme, hervorgerufen von elektronischen Komponenten (K) innerhalb des Schaltschranks (2), umfassend ein Übertragungsmittel (10) ausgestaltet die Verlustwärme von einem ersten Kühlmedium (M1) innerhalb des Schaltschranks (2) für die elektronischen Komponenten (K) durch das Übertragungsmittel (10) auf ein zweites Kühlmedium (M2) außerhalb des Schaltschanks (2) zu übertragen,
**gekennzeichnet**
**durch** eine Wanne (23) mit einer Oberseite (30), einer Unterseite (33), einer ersten Längsseite (31) und einer zweiten Längsseite (32), wobei
• In der Wanne (23) eine Ausnehmung (26,27) angeordnet ist und in der Ausnehmung (26,27) das Übertragungsmittel (10) angeordnet ist, wobei
• ein erstes Mediumleitblech (22) derart auf der Wanne (23) angeordnet ist, dass ein Strömungskanal für eine Außenströmung (AS) zwischen dem ersten Mediumleitblech (22) und der Wanne (23) entsteht, wobei das erste Mediumleitblech (22) ausgestaltet ist, dass das zweite Kühlmedium (M2) an der Unterseite (33) eintritt und an der Oberseite (30) austritt, wobei
• ein zweites Mediumleitblech (24) derart auf der dem ersten Mediumleitblech (22) gegenüberliegenden Seite der Wanne (23) angeordnet ist, dass ein Strömungskanal für eine Innenströmung (IS) zwischen dem zweiten Luftleitblech (24) und der Wanne (23) entsteht, wobei das zweite Mediumleitblech (22) ausgestaltet ist, dass das erste Kühlmedium (M1) an der Oberseite (30) eintritt und an der Unterseite (33) austritt,
• wodurch eine senkrechte und gegenläufige Führung von Außenströmung (AS) zu Innenströmung (IS) erreicht wird.

2. Wärmetauscheranordnung (1) nach Anspruch 1,
wobei das erstes Mediumleitblech (22) im Bereich der Unterseite (33) einen Einlass (28a, 28b) aufweist, in welchem ein Lüfter (L1,L2) zum Ansaugen des zweiten Mediums (M2) angeordnet ist.

3. Wärmetauscheranordnung (1) nach Anspruch 1 oder 2,
wobei das zweite Mediumleitblech (24) im Bereich der Oberseite (30) einen Einlass (29a, 29b) aufweist, in welchem ein weiterer Lüfter (L3,L4) zum Ansaugen des ersten Mediums (M1) angeordnet ist.

4. Wärmetauscheranordnung (1) nach einem der Ansprüche 1 bis 3,
wobei an der ersten Längsseite (31) ein erstes Haltemittel (41) und an der zweiten Längsseite (32) ein zweites Haltemittel (42) angeordnet ist.

5. Wärmetauscheranordnung (1) nach einem der Ansprüche 1 bis 4,
wobei das Übertragungsmittel (10) eine erste Rippenstruktur (R1) aufweist, welche derart angeordnet ist, dass das erste Kühlmedium (M1) eine vertikale Führung erfährt und somit eine Strömungsrichtung (SR1) des ersten Kühlmediums (M1) senkrecht ist.

6. Wärmetauscheranordnung (1) nach einem der Ansprüche 1 bis 5,
wobei das Übertragungsmittel (10) eine zweite Rippenstruktur (R2) aufweist, welche derart angeordnet ist, dass das zweite Kühlmedium (M2) eine vertikale Führung erfährt und somit eine Strömungsrichtung (SR2) des zweiten Kühlmediums (M2) senkrecht ist

7. Wärmetauscheranordnung (1) nach einem der Ansprüche 1 bis 4,
**dadurch gekennzeichnet,**
**dass** das Übertragungsmittel (10) eine Schichtstruktur mit einer ersten Schicht (11),
einer zweiten Schicht (12) und
einer dritten Schicht (13) aufweist, dabei ist zumindest die erste Schicht (11) aus einem Poren aufweisenden Stoff ausgestaltet, bei welchen ein Verhältnis eines Gesamtvolumens der ersten Schicht (11) zu einem durch die Poren gebildeten Hohlraumvolumen der ersten Schicht (11) derart optimiert ist, dass eine daraus resultierende Porengröße (PG) ein Optimum für eine Wärmeleitfähigkeit (L) der ersten Schicht (11) und einem Strömungswiderstand (R) für das erste Kühlmedium (M1) durch die Poren bildet.

8. Wärmetauscheranordnung (1) nach Anspruch 7,
wobei die zweite Schicht (12) aus einem Vollmaterial, welches für das erste Kühlmedium (M1) undurchlässig ist, ausgestaltet ist.

9. Wärmetauscheranordnung (1) nach Anspruch 7 oder 8,
wobei die dritte Schicht (13) aus einem Poren aufweisenden Stoff ausgestaltet ist, bei welchen ein Verhältnis eines Gesamtvolumens der dritten Schicht (13) zu einem durch die Poren gebildeten Hohlraumvolumen der dritten Schicht (13) derart optimiert ist, dass eine daraus resultierende Porengröße (PG) ein Optimum für eine Wärmeleitfähigkeit (L) der dritten Schicht (13) und einem Strömungswiderstand (R) für das zweite Kühlmedium (M2) durch die Poren bildet.

10. Wärmetauscheranordnung (1) nach einem der Ansprüche 7 bis 9,
wobei der Stoff ein poröses Aluminium ist.

11. Wärmetauscheranordnung (1) nach einem der Ansprüche 7 bis 10,
wobei der poröse Stoff derart ausgestaltet ist, dass im Wesentlichen alle Poren miteinander in Verbindung stehen und eine Porenmatrix (PM) vorhanden ist.

12. Wärmetauscheranordnung (1) nach einem der Ansprüche 7 bis 7,
wobei eine Porengröße (PG) im Bereich von 0,2 mm bis 2.0 mm liegt.

13. Wärmetauscheranordnung (1) nach einem der Ansprüche 1 bis 8,
ausgestaltet zur Integration in eine Rückwand eines Schaltschranks (2).

14. Schaltschrank (2) mit einem innerhalb des Schranks zur Rückseite (3) gerichteten Wärmetauscher (1) nach einem der Ansprüche 1 bis 13.
